# EUROPEAN PATENT SPECIFICATION

(11) **EP 3 273 316 B1**
(45) Date of publication and mention of the grant of the patent: **27.01.2021**
(21) Application number: 15886264.9
(22) Date of filing: 20.03.2015
(51) Int. Cl.: G05B 23/02, G05B 19/042, G01R 31/327

(54) **FAULT DIAGNOSIS METHOD AND CONTROL DEVICE**
FEHLERDIAGNOSEVERFAHREN UND STEUERUNGSVORRICHTUNG
PROCÉDÉ DE DIAGNOSTIC DE PANNE ET DISPOSITIF DE COMMANDE

(43) Date of publication of application: 24.01.2018
(73) Proprietor: Hitachi Industrial Equipment Systems Co., Ltd., Tokyo 101-0022 (JP)
(72) Inventor: ARAO, Yusuke, Tokyo 101-0022 (JP); TANAKA, Makoto, Tokyo 101-0022 (JP)
(74) Representative: Strehl Schübel-Hopf & Partner
(86) International application number: PCT/JP2015/058597
(87) International publication number: WO 2016/151707

(56) References cited:
- EP-A1- 1 722 248
- EP-A1- 2 085 836
- EP-A2- 1 857 900
- JP-A- 2004 103 031
- JP-A- 2009 115 825

## Description

### TECHNICAL FIELD

The present invention relates to a fault diagnosis method, and in particular, relates to a control device using the fault diagnosis method, and a power conversion device.

### BACKGROUND ART

JP 2013-104347 A (Patent Document 1) is provided as the background art of the technical field. In Patent Document 1, it is described that "an electronic control device includes a control unit controlling power feeding and an operation with respect to an assist motor, a fault diagnosis unit diagnosing a fault at the time of activating the control unit and during the operation of the control unit, and a CAN communication unit. In a case where the fault is diagnosed by the fault diagnosis unit, and the fault is detected, the control unit stops the power feeding to the assist motor, and after that, in a case where a signal representing the release of an idle stop state is received by the CAN communication unit from the other device, a fault is diagnosed again by the fault diagnosis unit. As the result of the diagnosis, in a case where a fault is detected, the power feeding with respect to the assist motor is continuously stopped, and in a case where a fault is not detected, the power feeding with respect to the assist motor is performed." (refer to Abstract).

Further, EP 1 857 900 A2 discloses a technique for switching the supply of power to a load, wherein a self-diagnosis function checks the operation of shutoff circuits every time the power to the load is to be switched on. EP 2 085 836 A1 discloses an electrical appliance which, when started, checks whether the electric contacts of switches for the supply of power to a load do not stick to each other. EP 1 722 248 A1 discloses a technique for diagnosing whether a relay can be controlled off within a normal response time.

### CITATION LIST

### PATENT DOCUMENT

Patent Document 1: JP 2013-104347 A

### SUMMARY OF THE INVENTION

### PROBLEMS TO BE SOLVED BY THE INVENTION

In Patent Document 1, a method is described in which the fault diagnosis unit diagnosing a fault at the time of activating the control unit and during the operation of the control unit is provided, and in a case where a fault is detected by the fault diagnosis unit, the power feeding with respect to the control target is stopped, and after that, in a case where the signal representing the release of the idle stop state is received by the receiving unit, a fault is diagnosed again by the fault diagnosis unit, and as the result of the diagnosis, in a case where a fault is detected, the power feeding with respect to the control target is continuously stopped, and in a case where a fault is not detected, the power feeding with respect to the control target is performed. However, a case where fault detect information is cleared after a power source is applied again to a system, is not considered. In addition, in this method, in a case where a fault is diagnosed again by the fault diagnosis unit, and the fault is not detected, the power feeding with respect to the control target is performed, but it is difficult for the user to recognize that a fault is observed.

An object of the present invention is to provide a mechanism in which a fault after a power source is applied is immediately observed and is easily recognized by a user, and failsafe is further obtained.

### SOLUTIONS TO PROBLEMS

The above problem Is solved by a fault diagnosis method, a power conversion device and a control device in accordance with the appended claims.

### EFFECTS OF THE INVENTION

According to the present invention, a fault is observed after the power source applied to the control device, and thus, it is possible to provide a mechanism in which an awareness is early promoted.

Objects, configurations, and effects other than those described above will be obvious by the description of the following embodiment.

### BRIEF DESCRIPTION OF THE DRAWINGS

Fig. 1 is an example of a system configuration diagram in Examples 1 and 2.
Fig. 2 is an example of a configuration diagram of a control device in Example 1.
Fig. 3 is a flow chart illustrating an operation of a fault diagnosis unit in Examples 1 and 2.
Fig. 4 is a timing chart illustrating a normal operation of the control device in Example 1.
Fig. 5 is a timing chart illustrating an abnormal operation of the control device in Example 1.
Fig. 6 is an example of a configuration diagram of a control device in Example 2.
Fig. 7 is a flow chart illustrating an operation of a mutual monitoring unit in Example 2.
Fig. 8 is a timing chart illustrating a normal operation of the control device in Example 2.
Fig. 9 is a timing chart illustrating an abnormal operation of the control device in Example 2.

### MODE FOR CARRYING OUT THE INVENTION

Hereinafter, examples will be described by using the drawings.

### Example 1

In this example, an example of a system in which a safe path of a single system is provided in a power conversion device and a control device having a safety function will be described.

In this example, a problem to be solved is that in a case where information of an internal fault is lost and the control unit is not activated after the reapplication of a power source which is started again after the power source of the system is cut off, it is necessary to wait for a timing where diagnosis is performed again in order to observe a fault, and thus, there is a possibility that it takes time to observe a fault. In addition, in a case where the fault diagnosis unit diagnoses again a fault, and the fault is not detected, it is difficult for a user to recognize that a fault is observed at the time of performing power feeding with respect to the control target. Accordingly, in this example, a mechanism is provided in which a fault after a power source is applied is immediately observed and is easily recognized by the user, and failsafe is further obtained.

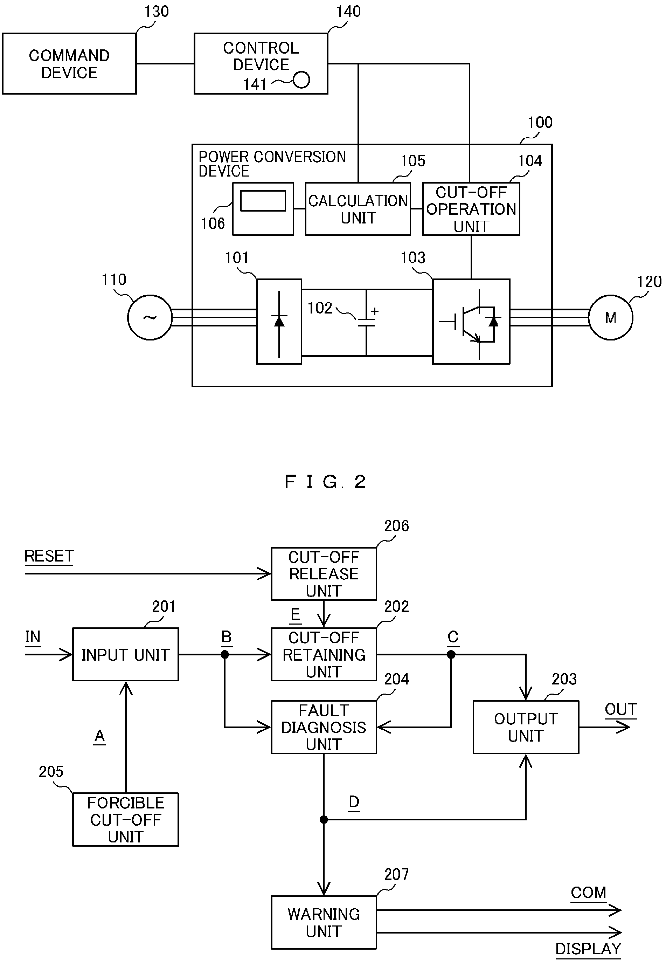

Fig. 1 is a system including a control device 140 of this example. In Fig. 1, this system includes a power conversion device 100, a power source 110, an alternating current motor 120, a command device 130, and the control device 140.

The power conversion device 100 sets power from the power source 110 and a cut-off command from the control device 140 as an input, and supplies the power to the alternating current motor 120. The power conversion device 100 includes a direct current conversion unit 101, a smooth portion 102, an alternating current conversion unit 103, a cut-off operation unit 104, a calculation unit 105, and a display operation unit 106.

The power source 110 sets three-phase alternating current power supplied from an electric power company or an electric power generator or a direct current power source supplied from a battery power source as an input, and supplies the power to the power conversion device 100. In a case where the power source 110 is an alternating current power source, the power source 110 may be connected to the direct current conversion unit 101 of the power conversion device 100, and in a case where the power source 110 may be a direct current power source, the power source 110 is directly connected to the smooth portion 102.

The alternating current motor 120 is a motor which is driven by the power supplied from the power conversion device 100, and for example, is configured of a synchronous motor or an induction motor.

The command device 130, for example, is configured of a push switch, a relay, a PLC, or in particular, a safety module such as a safety switch, a safety relay, a safety PLC, and a light curtain insofar as the command device 130 is a system relevant to functional safety, and outputs a safety function command to the control device 140 according to a method designated in advance by the user. The command device 130 outputs a reset signal of a separate system to the control device 140 along with the safety function command. The safety function command and the reset command performed by the command device 130 may be configured of modules different from each other.

The control device 140 sets the safety command output from the command device 130 as an input, outputs a cut-off command to the cut-off operation unit 104, and outputs a fault state to the calculation unit 105. Furthermore, the control device 140 may be separated from the power conversion device 100, or may be embedded in the power conversion device 100 as a circuit or a module, but the function thereof is not changed. The control device 140 includes a display unit 141 displaying the information of the internal fault. In a case where the power source is not applied to the control device 140 itself, the control device 140 outputs a cut-off state to the power conversion device 100.

The direct current conversion unit 101, for example, is configured of a direct current conversion circuit which is configured of a diode or a direct current conversion circuit using an IGBT and a flywheel diode, converts an alternating current voltage input from the three-phase alternating current power source 110 into a direct current voltage, and outputs the direct current voltage to the smooth portion 102. In Fig. 1, a direct current conversion unit configured of a diode is illustrated.

The smooth portion 102 smooths the direct current voltage input from the direct current conversion unit 101, for example, with a smooth capacitor, and outputs the direct current voltage to the alternating current conversion unit 103. In a case where the output of the electric power generator, for example, is a direct current voltage, the direct current voltage may be directly input into the smooth portion 102 from the electric power generator without passing through the direct current conversion unit 101.

The alternating current conversion unit 103, for example, is configured of an alternating current conversion circuit using an IGBT and a flywheel diode. The alternating current conversion unit 103 sets the direct current voltage from the smooth portion 102 and a PWM output waveform output from the calculation unit 105 through the cut-off operation unit 104 as an input, converts the direct current voltage into an alternating current voltage, and outputs the alternating current voltage to the alternating current motor 120.

The cut-off operation unit 104 sets the cut-off command of the control device 140 as an input, operates the PWM waveform input from the calculation unit 105 according to the cut-off command, and outputs the PWM waveform to the alternating current conversion unit 103. In Example 1, an example of the single system is described, and the cut-off command may be received and the cut-off may be performed, according to each cut-off input of a dual system or a triple system.

The calculation unit 105 sets a dynamic command or a command set in advance from the display operation unit 106 as an input, performs PWM command calculation, and outputs a PWM output command to the alternating current conversion unit 103 through cut-off operation unit 104. The calculation unit 105 sets fault information from the control device 140 as an input, performs fault analysis, and outputs the fault information to the display operation unit 106.

The display operation unit 106 sets a frequency command or parameter data as a user interface, and outputs the frequency command or the parameter data to the calculation unit. The display operation unit 106 sets the fault information output from the calculation unit 105 as an input, and displays the fault state.

The display unit 141, for example, is configured of an LED, sets the fault state detected in the control device 140 as an input, and displays the fault state.

Fig. 2 is an example of an internal configuration of the control device 140 in this example. The control device 140 includes an input unit 201, a cut-off retaining unit 202, an output unit 203, a fault diagnosis unit 204, a forcible cut-off unit 205, a cut-off release unit 206, and a warning unit 207.

The input unit 201 sets a command signal (a signal IN) from the command device 130 and a command signal (a signal A) from the forcible cut-off unit 205 as an input, and in a case where any one of the inputs is a cut-off command, generates the cut-off command, and in the other case, generates a permission command, and outputs the command each of the cut-off retaining unit 202 and the fault diagnosis unit 204 (a signal B).

The cut-off retaining unit 202 sets the command signal (the signal B) from the input unit 201 and a command signal (a signal E) from the cut-off release unit 206 as an input, determines whether or not to perform cut-off retention, and outputs the cut-off command or the permission command to the output unit 203 and the fault diagnosis unit 204 (a signal C).

The output unit 203 sets the command signal (the signal C or a signal D) from the cut-off retaining unit 202 and the fault diagnosis unit 204 as an input, determines whether or not to perform cut-off, and outputs the cut-off command or the permission command to the cut-off operation unit 104.

The fault diagnosis unit 204 sets the command signal (the signal B) from the input unit 201 and the command signal (the signal C) from the cut-off retaining unit 202 as an input, and for example, in a case where the signal B is a cut-off command, and the signal C is a permission command, determines that there is a fault, and outputs the cut-off signal to the output unit 203 and the warning unit 207. For example, in a case other than the case where the signal B is the cut-off command, and the signal C is the permission command, the fault diagnosis unit 204 determines that it is normal, and outputs a permission signal to the output unit 203 and the warning unit 207. Furthermore, in the case of determining that there is a fault within a predetermined period of time, a state in which the output of the control device is in the cut-off state is retained until the power source of the control device is cut off regardless of the input with respect to the control device, even after the predetermined period of time elapses.

When the power source is applied to the control device 140, the forcible cut-off unit 205, for example, outputs the cut-off command to the input unit 201 for greater than or equal to 10 ms, in a case where time set in advance after the power is supplied to the control device 140 from the power conversion device 100 and the power source is started, for example, design time T during which a reaction is performed according to the command, is defined as 10 ms. The forcible cut-off unit 205, for example, includes a section in which a forcible cut-off command is output in a state where the output with respect to the alternating current motor 120 is stopped according to an output state of the power conversion device 100, and thus, is capable of periodically performing an inspection with respect to the inside of the circuit of the control device 140.

The cut-off release unit 206 sets the reset signal input from the command device 130 as an input, generates a cut-off release command, and outputs the cut-off release command to the cut-off retaining unit 202 (the signal E). In an application where the cut-off retaining unit 202 may not retain the cut-off state in the cut-off release unit 206, for example, in a case where a PLC or a relay on an upper level retains a cut-off command state, for example, switching is performed by a switch or the like, and thus, it is possible to set a release signal to be continuously transmitted.

The warning unit 207 sets the command signal from the fault diagnosis unit 204 as an input, and in a case where the cut-off signal is input, determines that there is a fault, and outputs the fault signal to the display unit 141 and the calculation unit 105.

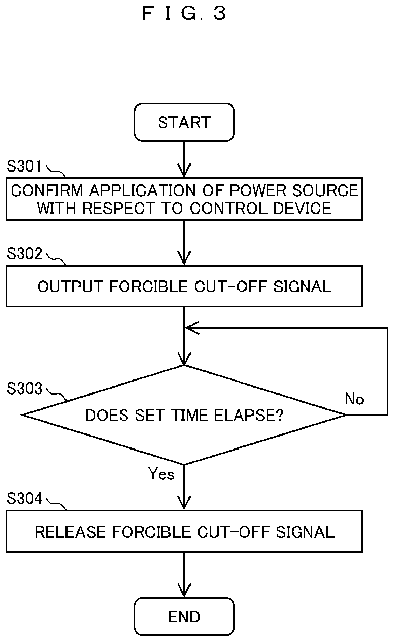

Fig. 3 is a flow chart illustrating an aspect in which the forcible cut-off unit 205 performs the cut-off command at the time of the application of the power source.

The forcible cut-off unit 205 confirms that the power source is applied to the control device 140 (S301), and outputs a forcible cut-off signal to the input unit 201 (S302). The forcible cut-off unit 205 waits for a predetermined period of time (S303), and after the set time elapses, switches the forcible cut-off signal to the permission signal (S304).

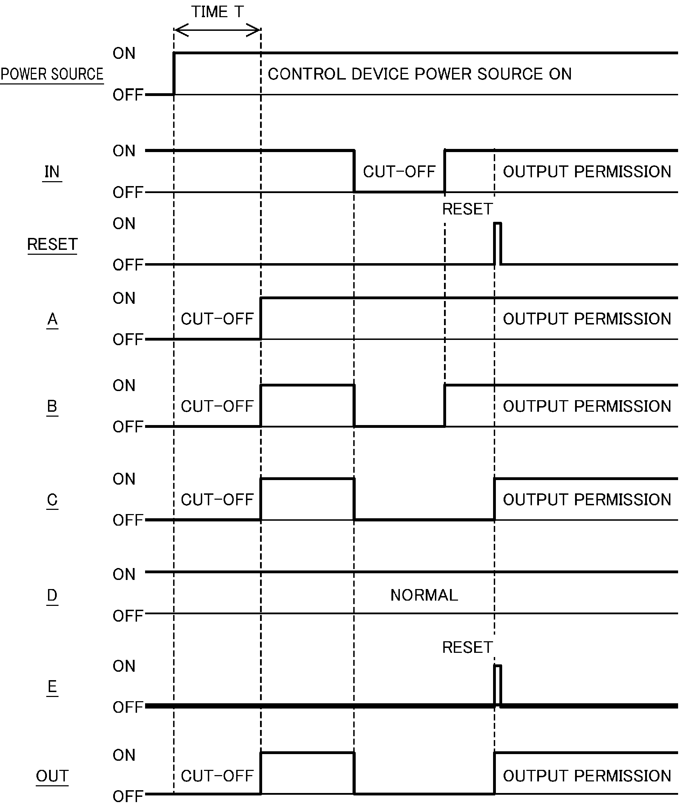

Fig. 4 illustrates a time chart of each signal in a normal state where the fault diagnosis unit 204 does not detect a fault.

In a case where the power source is applied to the control device 140, the forcible cut-off unit 205 outputs the cut-off signal to the signal A regardless of an input signal IN, and thus, in the case of a normal circuit, the cut-off command is output to the signals B and C, and an output OUT of the control device 140 is the cut-off command. The forcible cut-off unit 205 changes the signal A to the permission signal after fault detection time T elapses. In the control device 140, in a case where the cut-off signal is input into the input signal IN after the fault detection time elapses, the cut-off retaining unit 202 retains the cut-off state, and in a case where the release signal is input into a signal RESET, the cut-off retaining unit 202 releases the cut-off state. The output OUT of the control device 140 accords to the output of the cut-off retaining unit 202, and the permission signal and the cut-off signal are switched. In the control device 140, a normal signal is output to a display and a COM from the warning unit 207 unless the fault diagnosis unit 204 defects a fault.

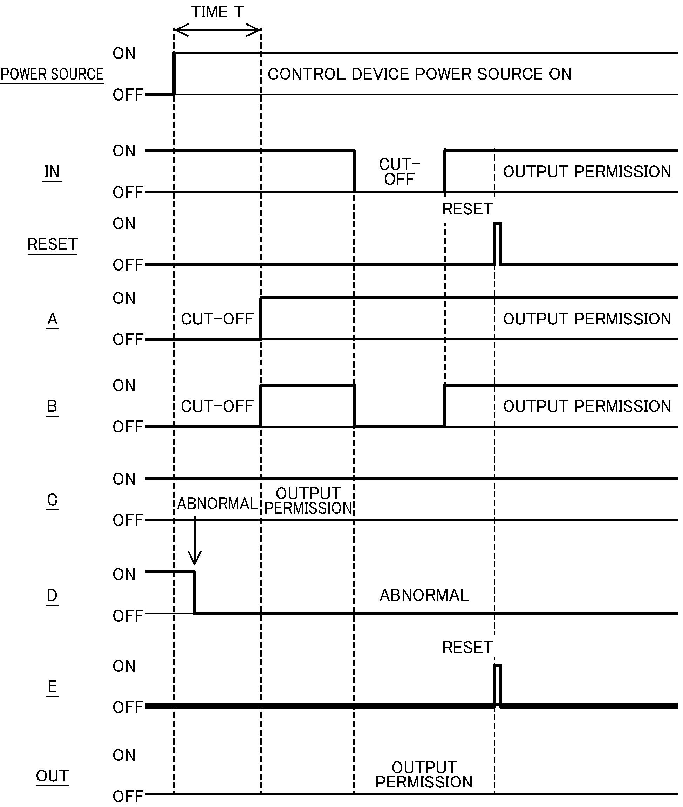

Fig. 5 illustrates a time chart of each signal when the fault diagnosis unit 204 detects a fault.

In a case where the power source is applied to the control device 140, the forcible cut-off unit 205 outputs the cut-off signal to the signal A regardless of the input signal IN. Accordingly, in the case of an abnormal circuit state where the signal B is in the cut-off state, but the signal C is an output permission, the fault diagnosis unit 204 determines that it is an abnormal state, and outputs the cut-off signal as the signal D. The abnormal state is observed in the control device 140, and thus, the control device 140 outputs the cut-off signal as the signal OUT. The forcible cut-off unit 205 changes the signal A to the permission signal after the fault detection time T elapses. In the control device 140, the output OUT of the control device 140 accords to the output of the fault diagnosis unit 204 and the cut-off signal is output, regardless of the state of the input signal IN and the signal RESET, after the fault detection time elapses. In the control device 140, in a case where the fault diagnosis unit 204 detects a fault, an abnormal signal is output to the display and the COM from the warning unit 207.

Accordingly, in this example, it is disclosed that in a case where the application of the power source is started again after being cut off, a potential is started from the cut-off state by the internal circuit, and thus, the application of the power source is started from the cut-off state, that is, a safe state, and a change towards an operation permission side occurs. Accordingly, even in a case where the information of the internal fault is lost, the state is changed, and thus, even in a case where the circuit is broken at the time of the application of the power source, recognition can be performed, and therefore, fault recognition can be immediately performed. Accordingly, it is possible to perform a fault inspection after the application of the power source.

As described above, in this example, the fault diagnosis method of the control device controlling the power supply with respect to the control target is configured such that the input with respect to the control device is started in the state which is equivalent to the cut-off state regardless of the input when the power source is applied to the control device, and the cut-off state is retained for the predetermined period of time.

In addition, the control device is configured such that the control device includes the cut-off retaining unit controlling the power supply with respect to the control target, the fault diagnosis unit diagnosing a fault in the cut-off retaining unit, and the forcible cut-off unit starts the input with respect to the control device in the state which is equivalent to the cut-off state regardless of the input when the power source is applied to the control device and retaining the cut-off state for the predetermined period of time.

In addition, the power conversion device including the control device is configured such that the control device includes the cut-off retaining unit controlling the power supply with respect to the control target, the fault diagnosis unit diagnosing a fault in the cut-off retaining unit, and the forcible cut-off unit starts the input with respect to the control device in the state which is equivalent to the cut-off state regardless of the input when the power source is applied to the control device and retaining the cut-off state for the predetermined period of time.

Accordingly, a fault is observed after the power source is applied to the control device, and thus, it is possible to provide a mechanism in which an awareness is early promoted.

### Example 2

In this example, an example of a system in which a safe path of a dual system is provided in the power conversion device and the control device having a safety function will be described.

In this example, the same reference numerals are applied to the same portions as those of Example 1, and different portions will be described in detail. In this example, a system configuration including the control device 140 of is identical to that of Fig. 1 described in Example 1. Here, in Example 1, the configuration example of the single system has been described, but in this example, the dual system is provided, and thus, in this example, the command device 130, the control device 140, and the cut-off operation unit 104 cut off the output from the calculation unit 105 by the cut-off operation unit 104 according to two different paths. In addition, the cut-off operation unit 104 is capable of setting the output with respect to the alternating current conversion unit 103 to be in the cut-off state insofar as any one of the paths is the cut-off state.

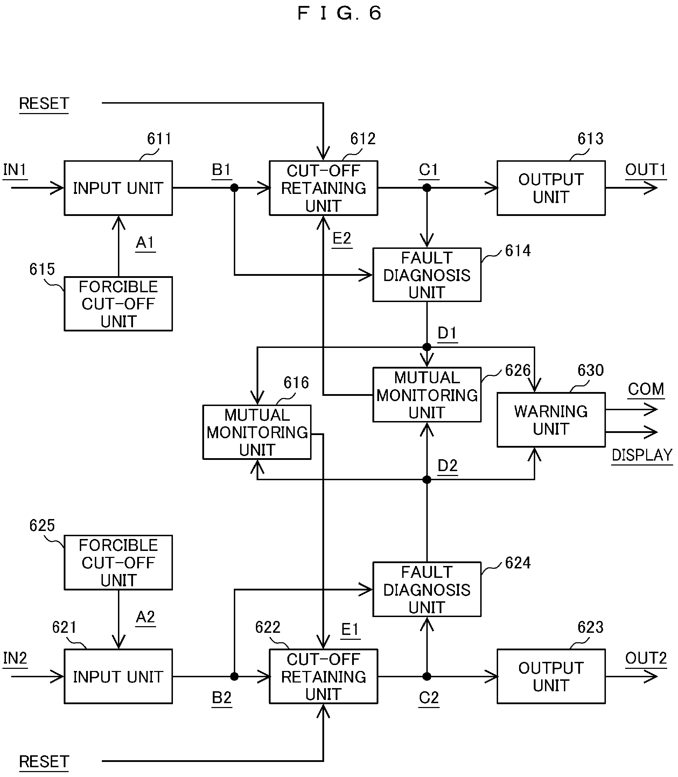

Fig. 6 is an example of an internal configuration of the control device 140 in this example. The control device 140 includes input units 611 and 621, cut-off retaining units 612 and 622, output units 613 and 623, fault diagnosis units 614 and 624, forcible cut-off units 615 and 625, mutual monitoring units 616 and 626, and a warning unit 630.

In a dual path in the control device 140, each path performs the same operation, and thus, the operation on one side will be described in detail. In addition, in the dual path in the control device 140, in a case where the same operation is performed with respect to each block element, different elements and different methods may be used for a circuit configuring the inside of the block, but the function thereof is not changed.

A path on a signal IN1 side input into the control device 140 will be described as an example.

The input unit 611 sets the command signal (the signal IN1) from the command device 130 and the command signal (a signal A1) from the forcible cut-off unit 615 as an input, and in a case where any one of the inputs is the cut-off command, generates the cut-off command, and in the other case, generates the permission command, and outputs the permission command to each of the cut-off retaining unit 612 and the fault diagnosis unit 614 (a signal B1).

The cut-off retaining unit 612 sets the command signal (the signal B1) from the input unit 611 and the reset signal (the signal RESET) from the command device 130 as an input, determines whether or not to perform the cut-off retention, and outputs the cut-off command or the permission command to the output unit 613 and the fault diagnosis unit 614 (a signal C1) .

The output unit 613 sets the cut-off command or the permission command (the signal C1) from the cut-off retaining unit 612 as an input, determines whether or not to perform the cut-off, and outputs the cut-off command or the permission command to the cut-off operation unit 104.

The fault diagnosis unit 614 sets the command signal of the input unit 611 (the signal B1) and the command signal of the cut-off retaining unit 612 (the signal C1) as an input, and for example, in a case where the signal B1 is the cut-off command, and the signal C1 is the permission command, determines that there is a fault, and outputs the cut-off signal to the mutual monitoring unit 616. In a case other than the case where the signal B1 is the cut-off command, and the signal C1 is the permission command, the fault diagnosis unit 614, for example, determines that it is normal, and outputs the permission signal to the mutual monitoring unit 616. Furthermore, in the case of determining that there is a fault within the predetermined period of time, a state in which the output of the control device is in the cut-off state is retained until the power source of the control device is cut off regardless of the input with respect to the control device, even after the predetermined period of time elapses.

When the power source is applied to the control device 140, the forcible cut-off unit 615, for example, outputs the cut-off command to the input unit 611 for greater than or equal to 10 ms, in a case where time set in advance after the power is supplied to the control device 140 from the power conversion device 100 and the power source is started, for example, the design time T during which a reaction is performed according to the command, is defined as 10 ms. The forcible cut-off unit 615, for example, includes a section in which the forcible cut-off command is output in a state where the output with respect to the alternating current motor 120 is stopped according to the output state of the power conversion device 100, and thus, is capable of periodically performing an inspection with respect to the inside of the circuit of the control device 140. The forcible cut-off units 615 and 625 are operated according to the flow chart described in Fig. 3 of Example 1.

The mutual monitoring unit 616 sets a command signal (D1) output from the fault diagnosis unit 614, as a diagnosis result of a path of an IN1 signal, and a command signal (D2) output from the fault diagnosis unit 624, as a diagnosis result of a path of an IN2 signal, as an input, and in a case where any one of the signals is the cut-off command signal, outputs a cut-off signal (E1) to the cut-off retaining unit 622 on the opposite side. The mutual monitoring units 616 and 626 monitors a mutual fault state, and thus, even in a case where a fault is observed in any one of the paths, it is possible to cut off at least one path.

The warning unit 630, sets the command signal from the fault diagnosis units 614 and 624 as an input, and in a case where the cut-off signal is input, determines that there is a fault, and outputs whether or not there is a fault in any path to the display unit 141 and the calculation unit 105 as a fault signal.

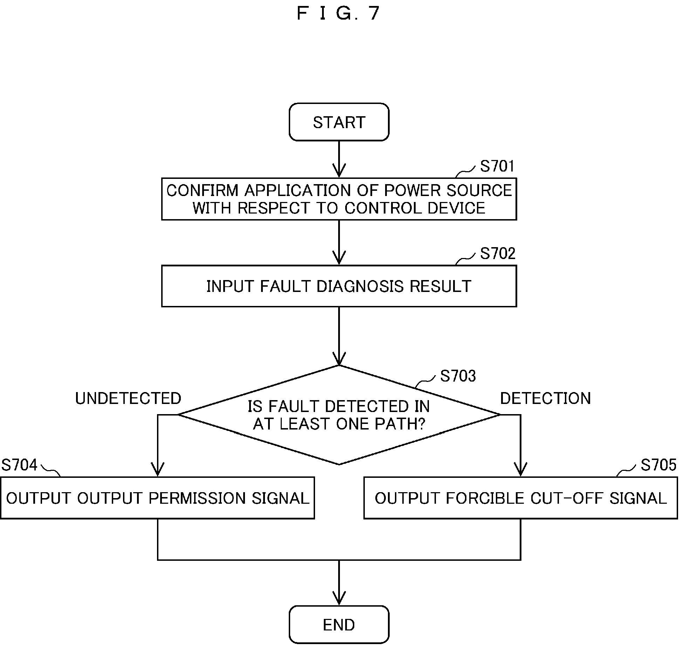

Fig. 7 is a flow chart illustrating an aspect in which the mutual monitoring unit 616 performs a cut-off retention command at the time of the application of the power source.

The mutual monitoring unit 616 confirms that the power source is applied to the control device 140 (S701), and inputs a diagnosis result of the fault diagnosis unit 614 according to the cut-off signal output from the forcible cut-off unit 615 (S702). The mutual monitoring unit 616 determines whether or not a fault is detected in at least one of two paths (S703), and in a case where both of the paths are normal, outputs an output permission signal to the cut-off retaining unit 622 (S704), and in a case where a fault is detected in at least one path, outputs the forcible cut-off signal to the cut-off retaining unit 622 (S705).

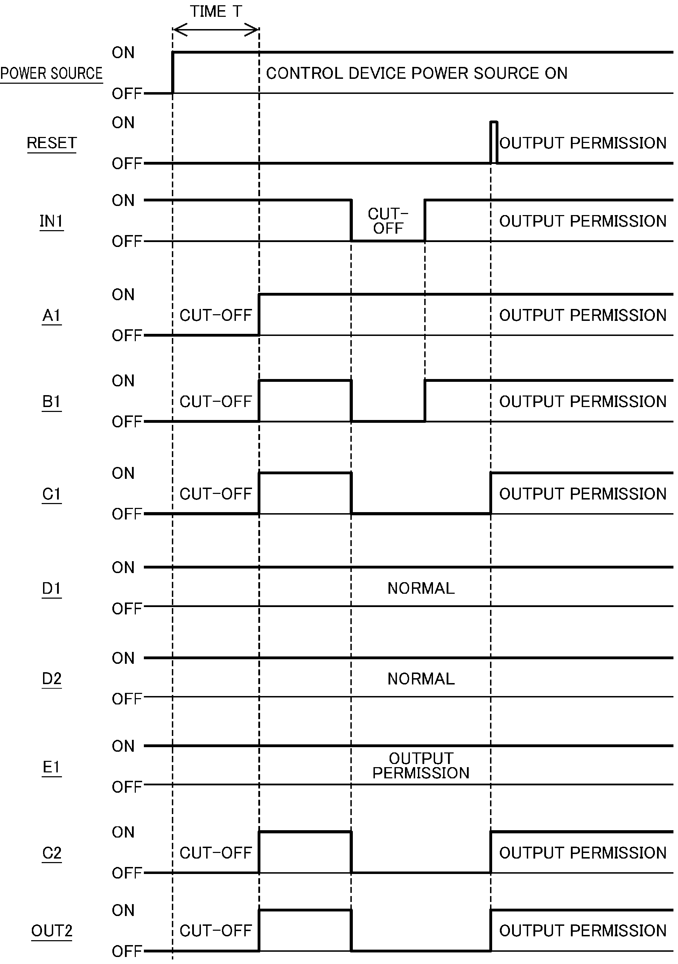

Fig. 8 illustrates a time chart of each signal for determining the output of the output unit 623 on the opposite side in two paths in a normal state where the fault diagnosis unit 614 does not detect a fault.

In a case where the power source is applied to the control device 140, the forcible cut-off unit 615 outputs the cut-off signal to the signal A1 regardless of the input signal IN1, and thus, in the case of a normal circuit, the cut-off command is output to the signals B1 and C1, and the fault diagnosis unit 614 determines that there is no fault, and outputs the normal signal as the signal D1. The mutual monitoring unit 616 sets the signals D1 and D2, which are the normal signal, as an input, determines that it is normal, and outputs the signal E1 to the cut-off retaining unit 622 as the output permission. The output unit 623 outputs the output permission signal to OUT2 according to the signal C2, which is the output permission signal. In the control device 140, the normal signal is output to the display and the COM from the warning unit 630 unless the fault diagnosis unit 614 or 624 detects a fault. The warning unit 630 is capable of determining which path has a fault according to the result of the fault diagnosis units 614 and 624, and thus, may output each state of a path fault. In a case where internal retention is not performed in the normal state, the control device 140 allows a state where the RESET signal is input to be continued, and thus, in a case where the fault diagnosis unit 614 or 624 does not detect a fault, it is possible to operate the output signal OUT1 or OUT2 according to the input signal IN1 or IN2.

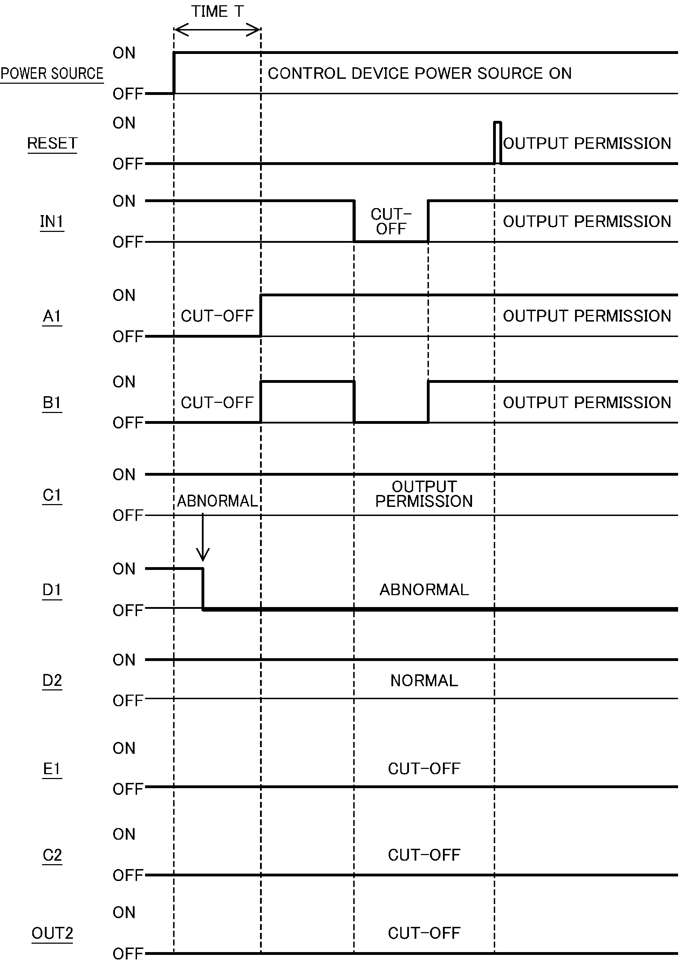

Fig. 9 illustrates a time chart of each signal for determining the output of the output unit 623 on the opposite side in two paths in an abnormal state where the fault diagnosis unit 614 detects a fault.

In a case where the power source is applied to the control device 140, the forcible cut-off unit 615 outputs the cut-off signal A1 regardless of the input signal IN1. Accordingly, in the case of the abnormal circuit state where the signal B1 is the cut-off state, and the signal C1 is the output permission, the fault diagnosis unit 614 determines that it is an abnormal state, and outputs the cut-off signal to the mutual monitoring unit 616 as the signal D1. In a case where the signal D1, which is the abnormal, and the signal D2, which is normal, are input, the mutual monitoring unit 616 determines that an abnormal state is observed, and outputs the signal E1 as a command for retaining the cut-off of the cut-off retaining unit 622 on a path opposite side to a path which is abnormal. In the cut-off retaining unit 622, the cut-off state is not released, and thus, the output unit 623 outputs an output cut-off signal to OUT2 according to the signal C2, which is the output cut-off signal. In the control device 140, in a case where the fault diagnosis unit 614 or 624 detects a fault, the abnormal signal from the warning unit 630 is output to the display and the COM. The warning unit 630 is capable of determining which path has a fault according to the result of the fault diagnosis units 614 and 624, and thus, may output each state of a path fault. In a case where an abnormality is observed in the control device 140, at least one of the output signals OUT1 and OUT2 can be output in the cut-off state, regardless of the input signals IN1 and IN2, and the signal RESET signal.

As described above, in this example, the fault diagnosis method of the control device controlling the power supply with respect to the control target is configured such that the input with respect to the control device is started in the state which is equivalent to the cut-off state regardless of the input when the power source is applied to the control device, and the cut-off state is retained for the predetermined period of time, and the control device has a dual system configuration, and in a case where one system in the dual system determines that there is a fault within the predetermined period of time, the state in which the output of the control device is in the cut-off state is retained until the power source of the control device is cut off regardless of the input with respect to the control device, even after the predetermined period of time elapses.

In addition, the control device is configured such that the control device includes the cut-off retaining unit controlling the power supply with respect to the control target, the fault diagnosis unit diagnosing a fault in the cut-off retaining unit, and the forcible cut-off unit starts the input with respect to the control device in the state which is equivalent to the cut-off state regardless of the input when the power source is applied to the control device and retaining the cut-off state for the predetermined period of time, and the control device includes the cut-off retaining unit, the forcible cut-off unit, and the fault diagnosis unit separately in the two paths, and further includes the mutual monitoring unit mutually monitoring the two paths, and in a case where the fault diagnosis unit on a separate path side in the two paths or the fault diagnosis unit of any one of the two paths determines that there is a fault within the predetermined period of time, the mutual monitoring unit retains the state in which the output of the control device is cut off until the power source of the control device is cut off regardless of the input with respect to the control device, even after the predetermined period of time elapses.

Accordingly, the system of this example is capable of performing an inspection of a fault after the application of the power source.

### REFERENCE SIGNS LIST

- 100: power conversion device
- 110: power source
- 120: alternating current motor
- 130: command device
- 140: control device
- 101: direct current conversion unit
- 102: smooth portion
- 103: alternating current conversion unit
- 104: cut-off operation unit
- 105: calculation unit
- 106: display operation unit
- 141: display unit
- 201: input unit
- 202: cut-off retaining unit
- 203: output unit
- 204: fault diagnosis unit
- 205: forcible cut-off unit
- 206: cut-off release unit
- 207: warning unit
- 611: input unit
- 612: cut-off retaining unit
- 613: output unit
- 614: fault diagnosis unit
- 615: forcible cut-off unit
- 616: mutual monitoring unit
- 621: input unit
- 622: cut-off retaining unit
- 623: output unit
- 624: fault diagnosis unit
- 625: forcible cut-off unit
- 626: mutual monitoring unit
- 630: warning unit

## Claims

1. A fault diagnosis method of a control device (140) having an output (OUT) connected to a power conversion device (100) supplying power to a control target, the control device comprising an input unit (201) having an input for receiving an input signal (IN), a cut-off retaining unit (202) controlling the power supply to the control target, a fault diagnosis unit (204) diagnosing a fault in the cut-off retaining unit (202), and a forcible cut-off unit (205),
wherein the input unit (201) has another input for receiving a first signal (A) from the forcible cut-off unit (205) and outputs a second signal (B) with a cut-off command to the cut-off retaining unit (202) when either of its inputs receives the input signal or first signal with a cut-off command, and the cut-off retaining unit (202) has an input for receiving said second signal (B) with the cut-off command from the input unit (201) and another input for receiving a third signal (E) with a release command,
wherein when a power source is applied to the control device (140), the forcible cut-off unit (205) outputs the first signal (A) with the cut-off command to the input unit (201) for a predetermined period of time (T) so that the input unit (202) is started in a cut-off state where it outputs the second signal (B) with the cut-off command to the cut-off retaining unit (202) regardless of the input signal (IN), and the cut-off state is retained for the predetermined period of time (T), and
wherein when the input signal (IN) with the cut-off command is input after the predetermined time (T) has elapsed without a fault having been determined, the cut-off retaining unit (202) retains the cut-off state, and when the third signal (E) with the release command is input, the cut-off retaining unit (202) releases the cut-off state, whereby the output (OUT) of the control device accords to an output of the cut-off retaining unit (202) and switches between outputting a cut-off signal and a permission signal to the power conversion device (100),
whereas in the case of the fault diagnosis unit (204) determining that there is a fault within the predetermined period of time (T), the output (OUT) of the control device (140) is retained in the cut-off state outputting the cut-off signal to the power conversion device (100) until the power source of the control device is cut off, regardless of said input signal (IN) and said third signal (E), even after the predetermined period of time (T) has elapsed.

2. The fault diagnosis method according to claim 1,
wherein the control device (140) has a dual system configuration, and
in a case where one of the systems (611∼616, 621∼626) in the dual system determines that there is a fault within the predetermined period of time (T), the output of the control device (140) is retained in the cut-off state until the power source of the control device is cut off regardless of the input signal (IN) to the control device (140), even after the predetermined period of time (T) has elapsed.

3. A control device (140), comprising:
an input unit (201) having an input for receiving an input signal (IN);
a cut-off retaining unit (202) for controlling power supply to a control target;
a fault diagnosis unit (204) for diagnosing a fault in the cut-off retaining unit (202); and
a forcible cut-off unit (205),
**characterised in that**
the control device has an output (OUT) for connection to a power conversion device (100) supplying power to a control target,
the input unit (201) has another input for receiving a first signal (A) from the forcible cut-off unit (205), and is configured to output a second signal (B) with a cut-off command to the cut-off retaining unit (202) when either of its inputs receives the input signal or first signal with a cut-off command,
the cut-off retaining unit (202) has an input for receiving said second signal (B) with the cut-off command from the input unit (201) and another input for receiving a third signal (E) with a release command, and
the forcible cut-off unit (205) is configured to output, when a power source is applied to the control device (140), the first signal (A) with the cut-off command to the input unit (201) for a predetermined period of time (T) thereby starting the input unit (202) in a cut-off state where it outputs the second signal (B) with the cut-off command to the cut-off retaining unit (202) regardless of the input signal (IN), and retaining the cut-off state for the predetermined period of time (T),
wherein when the input signal (IN) with the cut-off command is input after the predetermined time (T) has elapsed without a fault having been determined, the cut-off retaining unit (202) is configured to retain the cut-off state, and when the third signal (E) with the release command is input, the cut-off retaining unit (202) is configured to release the cut-off state, whereby the output (OUT) of the control device accords to an output of the cut-off retaining unit (202) and switches between outputting a cut-off signal and a permission signal to the power conversion device (100),
whereas in the case of the fault diagnosis unit (204) determining that there is a fault within the predetermined period of time (T), the fault diagnosis unit (204) is configured to retain the output (OUT) of the control device (140) in the cut-off state for outputting the cut-off signal to the power conversion device (100), until the power source of the control device is cut off, regardless of said input signal (IN) and said third signal (E), even after the predetermined period of time (T) has elapsed.

4. The control device according to claim 3,
wherein the control device (140) includes the cut-off retaining unit (612, 622), the forcible cut-off unit (615, 625), and the fault diagnosis unit (614, 624) each twice separately in two paths, and further includes a mutual monitoring unit (616, 626) for mutually monitoring the two paths, and
in a case where the fault diagnosis unit (614, 624) of either of the two paths determines that there is a fault within the predetermined period of time (T), the mutual monitoring unit (616, 626) is configured to retain a state in which the output of the control device (140) is cut off until the power source of the control device is cut off, regardless of the input signal (IN) to the control device (140), even after the predetermined period of time (T) has elapsed.

5. The control device according to any one of claims 3 to 4, further comprising:
a display unit (141) for imparting a warning to the outside,
wherein in a case where a fault is observed on an internal path, the display unit (141) is configured to perform display to impart the warning to a user.

6. The control device according to any one of claims 3 to 4, further comprising:
a warning unit (207) for imparting a warning signal to the outside,
wherein in a case where a fault is observed on an internal path, the warning unit (207) is configured to impart the warning signal to an outside device.

7. A system comprising a power conversion device and a control device in accordance with claim 3.

## Patentansprüche

1. Fehlerdiagnoseverfahren für eine Steuervorrichtung (140) mit einem Ausgang (OUT), der mit einer einem Steuerobjekt Energie zuführenden Leistungswandler-Vorrichtung (100) verbunden ist, wobei die Steuervorrichtung eine Eingangseinheit (201) mit einem Eingang zur Entgegennahme eines Eingangssignals (IN), eine Abschalthalteeinheit (202) zum Steuern der Energiezufuhr zum Steuerobjekt, eine Fehlerdiagnoseeinheit (204) zum Diagnostizieren eines Fehlers in der Abschalthalteeinheit (202) und eine Zwangsabschalteinheit (205) umfasst,
wobei die Eingangseinheit (201) einen weiteren Eingang zur Entgegennahme eines ersten Signals (A) von der Zwangsabschalteinheit (205) aufweist und ein zweites Signal (B) mit einem Abschaltbefehl an die Abschalthalteeinheit (202) ausgibt, wenn irgendeiner ihrer Eingänge das Eingangssignal oder erste Signal mit einem Abschaltbefehl entgegennimmt, und die Abschalthalteeinheit (202) einen Eingang zur Entgegennahme des zweiten Signals (B) mit dem Abschaltbefehl von der Eingangseinheit (201) sowie einen weiteren Eingang zur Entgegennahme eines dritten Signals (E) mit einem Freigabebefehl aufweist,
wobei dann, wenn an die Steuereinheit (140) eine Energiequelle angelegt wird, die Zwangsabschalteinheit (205) das erste Signal (A) mit dem Abschaltbefehl für eine vorbestimmte Zeitspanne (T) an die Eingangseinheit (201) ausgibt, sodass die Eingangseinheit (201) in einem Abschaltzustand gestartet wird, in dem sie ungeachtet des Eingangssignals (IN) das zweite Signal (B) mit dem Abschaltbefehl an die Abschalthalteeinheit (202) ausgibt, und der Abschaltzustand für die vorbestimmte Zeitspanne (T) gehalten wird, und
wobei dann, wenn das Eingangssignal (IN) mit dem Abschaltbefehl nach Ablauf der vorbestimmten Zeitspanne (T), ohne dass ein Fehler festgestellt wurde, eingegeben wird, die Abschalthalteeinheit (202) den Abschaltzustand hält, und wenn das dritte Signal (E) mit dem Freigabebefehl eingegeben wird, die Abschalthalteeinheit (202) den Abschaltzustand freigibt, wodurch der Ausgang (OUT) der Steuervorrichtung einem Ausgang der Abschalthalteeinheit (202) folgt und zwischen der Ausgabe eines Abschaltsignals und eines Erlaubnissignals an die Leistungswandler-Vorrichtung (100) wechselt,
wohingegen dann, wenn die Fehlerdiagnoseeinheit (204) bestimmt, dass innerhalb der vorbestimmten Zeitspanne (T) ein Fehler vorliegt, der Ausgang (OUT) der Steuervorrichtung (140) ungeachtet des Eingangssignals (IN) und des dritten Signals (E) und auch nach Ablauf der vorbestimmten Zeitspanne (T) im Abschaltzustand gehalten wird, in dem das Abschaltsignal an die Leistungswandler-Vorrichtung (100) ausgegeben wird, bis die Energiequelle für die Steuervorrichtung abgeschaltet wird.

2. Fehlerdiagnoseverfahren nach Anspruch 1,
wobei die Steuervorrichtung (140) eine Doppelsystemkonfiguration aufweist, und
dann, wenn eines der Systeme (611∼616, 621∼626) im Doppelsystem feststellt, dass innerhalb der vorbestimmten Zeitspanne (T) ein Fehler vorliegt, der Ausgang der Steuervorrichtung (140) ungeachtet des Eingangssignals (IN) für die Steuervorrichtung (140) und auch nach Ablauf der vorbestimmten Zeitspanne (T) im Abschaltzustand gehalten wird, bis die Energiequelle für die Steuervorrichtung abgeschaltet wird.

3. Steuervorrichtung (140) umfassend:
eine Eingangseinheit (201) mit einem Eingang zur Entgegennahme eines Eingangssignals (IN);
eine Abschalthalteeinheit (202) zum Steuern der Energiezufuhr zu einem Steuerobjekt;
eine Fehlerdiagnoseeinheit (204) zum Diagnostizieren eines Fehlers in der Abschalthalteeinheit (202); und
eine Zwangsabschalteinheit (205),
**dadurch gekennzeichnet, dass**
die Steuervorrichtung einen Ausgang (OUT) zur Verbindung mit einer Leistungswandler-Vorrichtung (100) aufweist, die einem Steuerobjekt Energie zuführt,
die Eingangseinheit (201) einen weiteren Eingang zur Entgegennahme eines ersten Signals (A) von der Zwangsabschalteinheit (205) aufweist und eingerichtet ist, ein zweites Signal (B) mit einem Abschaltbefehl an die Abschalthalteeinheit (202) auszugeben, wenn irgendeiner ihrer Eingänge das Eingangssignal oder erste Signal mit einem Abschaltbefehl entgegennimmt,
die Abschalthalteeinheit (202) einen Eingang zur Entgegennahme des zweiten Signals (B) mit dem Abschaltbefehl von der Eingangseinheit (201) und einen weiteren Eingang zur Entgegennahme eines dritten Signals (E) mit einem Freigabebefehl aufweist, und
die Zwangsabschalteinheit (205) eingerichtet ist, wenn eine Energiequelle an die Steuervorrichtung (140) angelegt wird, das erste Signal (A) mit dem Abschaltbefehl für eine vorbestimmte Zeitspanne (T) an die Eingangseinheit (201) auszugeben, wodurch die Eingangseinheit (201) in einem Abschaltzustand gestartet wird, in dem sie ungeachtet des Eingangssignals (IN) das zweite Signal (B) mit dem Abschaltbefehl an die Abschalthalteeinheit (202) ausgibt, und der Abschaltzustand für die vorbestimmte Zeitspanne (T) gehalten wird,
wobei dann, wenn das Eingangssignal (IN) mit dem Abschaltbefehl nach Ablauf der vorbestimmten Zeitspanne (T), ohne dass ein Fehler festgestellt wurde, eingegeben wird, die Abschalthalteeinheit (202) eingerichtet ist, den Abschaltzustand zu halten, und wenn das dritte Signal (E) mit dem Freigabebefehl eingegeben wird, die Abschalthalteeinheit (202) eingerichtet ist, den Abschaltzustand freizugeben, wodurch der Ausgang (OUT) der Steuervorrichtung einem Ausgang der Abschalthalteeinheit (202) folgt und zwischen der Ausgabe eines Abschaltsignals und eines Erlaubnissignals an die Leistungswandler-Vorrichtung (100) wechselt,
wohingegen dann, wenn die Fehlerdiagnoseeinheit (204) feststellt, dass innerhalb der vorbestimmten Zeitspanne (T) ein Fehler vorliegt, die Fehlerdiagnoseeinheit (204) eingerichtet ist, den Ausgang (OUT) der Steuervorrichtung (140) ungeachtet des Eingangssignals (IN) und des dritten Signals (E) und auch nach Ablauf der vorbestimmten Zeitspanne (T) im Abschaltzustand zu halten, um das Abschaltsignal an die Leistungswandler-Vorrichtung (100) auszugeben, bis die Energiequelle für die Steuervorrichtung abgeschaltet wird.

4. Steuervorrichtung nach Anspruch 3,
wobei die Steuervorrichtung (140), die Abschalthalteeinheit (612, 622), die Zwangsabschalteinheit (615, 625) und die Fehlerdiagnoseeinheit (614, 624) jeweils zweimal getrennt in zwei Pfaden enthält und außerdem eine gegenseitige Überwachungseinheit (616, 626) zum gegenseitigen Überwachen der beiden Pfade enthält, und
dann, wenn die Fehlerdiagnoseeinheit (614, 624) eines der beiden Pfade feststellt, dass innerhalb der vorbestimmten Zeitspanne (T) ein Fehler vorliegt, die gegenseitige Überwachungseinheit (616, 626) eingerichtet ist, ungeachtet des Eingangssignals (IN) für die Steuervorrichtung (140) und auch nach Ablauf der vorbestimmten Zeitspanne einen Zustand zu halten, in dem der Ausgang der Steuervorrichtung (140) abgeschaltet ist, bis die Energiequelle für die Steuervorrichtung abgeschaltet wird.

5. Steuervorrichtung nach einem der Ansprüche 3 bis 4, außerdem umfassend:
eine Anzeigeeinheit (141), um eine Warnung nach außen zu geben,
wobei dann, wenn auf einem internen Pfad ein Fehler beobachtet wird, die Anzeigeeinheit (141) eingerichtet ist, eine Anzeige zur Abgabe der Warnung an einen Benutzer vorzunehmen.

6. Steuervorrichtung nach einem der Ansprüche 3 bis 4, außerdem umfassend:
eine Warneinheit (207) zur Abgabe eines Warnsignals nach außen,
wobei dann, wenn ein Fehler auf einem internen Pfad beobachtet wird, die Warneinheit (207) eingerichtet ist, das Warnsignal an eine externe Vorrichtung abzugeben.

7. System mit einer Leistungswandler-Vorrichtung und einer Steuervorrichtung nach Anspruch 3.

## Revendications

1. Procédé de diagnostic de dysfonctionnement d'un dispositif de commande (140) ayant une sortie (OUT) connectée à un dispositif de conversion d'énergie (100) fournissant une énergie à une cible de commande, le dispositif de commande comprenant une unité d'entrée (201) ayant une entrée pour recevoir un signal d'entrée (IN), une unité de maintien de coupure (202) commandant la fourniture d'énergie à la cible de commande, une unité de diagnostic de dysfonctionnement (204) diagnostiquant un dysfonctionnement dans l'unité de maintien de coupure (202), et une unité de coupure forcée (205),
dans lequel l'unité d'entrée (201) a une autre entrée pour recevoir un premier signal (A) provenant de l'unité de coupure forcée (205) et délivre en sortie un deuxième signal (B) avec une commande de coupure à l'unité de maintien de coupure (202) lorsque l'une ou l'autre de ses entrées reçoit le signal d'entrée ou le premier signal avec une commande de coupure, et l'unité de maintien de coupure (202) a une entrée pour recevoir ledit deuxième signal (B) avec la commande de coupure provenant de l'unité d'entrée (201) et une autre entrée pour recevoir un troisième signal (E) avec une commande de libération,
dans lequel, lorsqu'une source d'énergie est appliquée au dispositif de commande (140), l'unité de coupure forcée (205) délivre en sortie le premier signal (A) avec la commande de coupure à l'unité d'entrée (201) sur une période de temps (T) prédéterminée de telle sorte que l'unité d'entrée (202) est démarrée dans un état de coupure où elle délivre en sortie le deuxième signal (B) avec la commande de coupure à l'unité de maintien de coupure (202) sans tenir compte du signal d'entrée (IN), et l'état de coupure est maintenu sur la période de temps (T) prédéterminée, et
dans lequel, lorsque le signal d'entrée (IN) avec la commande de coupure est entré après que le temps (T) prédéterminé s'est écoulé sans qu'un dysfonctionnement n'ait été déterminé, l'unité de maintien de coupure (202) maintient l'état de coupure, et lorsque le troisième signal (E) avec la commande de libération est entré, l'unité de maintien de coupure (202) libère l'état de coupure, d'où il résulte que la sortie (OUT) du dispositif de commande s'accorde sur une sortie de l'unité de maintien de coupure (202) et commute entre la délivrance en sortie d'un signal de coupure et d'un signal d'autorisation au dispositif de conversion d'énergie (100),
tandis que dans le cas de l'unité de diagnostic de dysfonctionnement (204) déterminant qu'il y a un dysfonctionnement à l'intérieur de la période de temps (T) prédéterminée, la sortie (OUT) du dispositif de commande (140) est maintenue dans l'état de coupure délivrant en sortie le signal de coupure au dispositif de conversion d'énergie (100) jusqu'à ce que la source d'énergie du dispositif de commande soit coupée, sans tenir compte dudit signal d'entrée (IN) et dudit troisième signal (E), même après que la période de temps (T) prédéterminée s'est écoulée.

2. Procédé de diagnostic de dysfonctionnement selon la revendication 1,
dans lequel le dispositif de commande (140) a un double système de configuration, et
dans un cas où un des systèmes (611∼616, 621∼626) dans le double système détermine qu'il y a un dysfonctionnement dans la période de temps (T) prédéterminée, la sortie du dispositif de commande (140) est maintenue dans l'état de coupure jusqu'à ce que la source d'énergie du dispositif de commande soit coupée, sans tenir compte du signal d'entrée (IN) au dispositif de commande (140), même après que la période de temps (T) prédéterminée s'est écoulée.

3. Dispositif de commande (140), comprenant :
une unité d'entrée (201) ayant une entrée pour recevoir un signal d'entrée (IN) ;
une unité de maintien de coupure (202) pour commander une fourniture d'énergie à une cible de commande ;
une unité de diagnostic de dysfonctionnement (204) pour diagnostiquer un dysfonctionnement dans l'unité de maintien de coupure (202) ; et
une unité de coupure forcée (205),
**caractérisé en ce que**
le dispositif de commande a une sortie (OUT) pour une connexion à un dispositif de conversion d'énergie (100) fournissant une énergie à une cible de commande,
l'unité d'entrée (201) a une autre entrée pour recevoir un premier signal (A) provenant de l'unité de coupure forcée (205), et est configurée pour délivrer en sortie un deuxième signal (B) avec une commande de coupure à l'unité de maintien de coupure (202) lorsque l'une ou l'autre de ses entrées reçoit le signal d'entrée ou le premier signal avec une commande de coupure,
l'unité de maintien de coupure (202) a une entrée pour recevoir ledit deuxième signal (B) avec la commande de coupure provenant de l'unité d'entrée (201) et une autre entrée pour recevoir un troisième signal (E) avec une commande de libération, et
l'unité de coupure forcée (205) est configurée pour délivrer en sortie, lorsqu'une source d'énergie est appliquée au dispositif de commande (140), le premier signal (A) avec la commande de coupure à l'unité d'entrée (201) sur une période de temps (T) prédéterminée, démarrant ainsi l'unité d'entrée (202) dans un état de coupure où elle délivre en sortie le deuxième signal (B) avec la commande de coupure à l'unité de maintien de coupure (202) sans tenir compte du signal d'entrée (IN), et maintenant l'état de coupure sur la période de temps (T) prédéterminée,
dans lequel, lorsque le signal d'entrée (IN) avec la commande de coupure est entré après que le temps (T) prédéterminé s'est écoulé sans qu'un dysfonctionnement n'ait été déterminé, l'unité de maintien de coupure (202) est configurée pour maintenir l'état de coupure, et lorsque le troisième signal (E) avec la commande de libération est entré, l'unité de maintien de coupure (202) est configurée pour libérer l'état de coupure, d'où il résulte que la sortie (OUT) du dispositif de commande s'accorde sur une sortie de l'unité de maintien de coupure (202) et commute entre la délivrance en sortie d'un signal de coupure et d'un signal d'autorisation au dispositif de conversion d'énergie (100),
tandis que dans le cas de l'unité de diagnostic de dysfonctionnement (204) déterminant qu'il y a un dysfonctionnement à l'intérieur de la période de temps (T) prédéterminée, l'unité de diagnostic de dysfonctionnement (204) est configurée pour maintenir la sortie (OUT) du dispositif de commande (140) dans l'état de coupure pour délivrer en sortie le signal de coupure au dispositif de conversion d'énergie (100), jusqu'à ce que la source d'énergie du dispositif de commande soit coupée, sans tenir compte dudit signal d'entrée (IN) et dudit troisième signal (E), même après que la période de temps (T) prédéterminée s'est écoulée.

4. Dispositif de commande selon la revendication 3,
dans lequel le dispositif de commande (140) inclut l'unité de maintien de coupure (612, 622), l'unité de coupure forcée (615, 625), et l'unité de diagnostic de dysfonctionnement (614, 624) chacune deux fois séparément dans deux voies, et inclut en outre une unité de surveillance mutuelle (616, 626) pour surveiller mutuellement les deux voies, et
dans un cas où l'unité de diagnostic de dysfonctionnement (614, 624) de l'une ou l'autre des deux voies détermine qu'il y a un dysfonctionnement à l'intérieur de la période de temps (T) prédéterminée, l'unité de surveillance mutuelle (616, 626) est configurée pour maintenir un état dans lequel la sortie du dispositif de commande (140) est coupée jusqu'à ce que la source d'énergie du dispositif de commande soit coupée, sans tenir compte du signal d'entrée (IN) au dispositif de commande (140), même après que la période de temps (T) prédéterminée s'est écoulée.

5. Dispositif de commande selon l'une quelconque des revendications 3 à 4, comprenant en outre :
une unité d'affichage (141) pour envoyer un avertissement à l'extérieur,
dans lequel, dans un cas où un dysfonctionnement est observé sur une voie interne, l'unité d'affichage (141) est configurée pour effectuer un affichage pour envoyer l'avertissement à un utilisateur.

6. Dispositif de commande selon l'une quelconque des revendications 3 à 4, comprenant en outre :
une unité d'avertissement (207) pour envoyer un signal d'avertissement à l'extérieur,
dans lequel, dans un cas où un dysfonctionnement est observé sur une voie interne, l'unité d'avertissement (207) est configurée pour envoyer le signal d'avertissement à un dispositif extérieur.

7. Système comprenant un dispositif de conversion d'énergie et un dispositif de commande selon la revendication 3.
